(19) Europäisches Patentamt / European Patent Office / Office européen des brevets

(11) **EP 2 922 093 B1**

(12) **EUROPEAN PATENT SPECIFICATION**

(45) Date of publication and mention
of the grant of the patent:
**10.05.2017   Bulletin 2017/19**

(51) Int Cl.:
*H01L 27/06* (2006.01)          *H01L 27/02* (2006.01)
*H01L 29/778* (2006.01)          *H01L 23/34* (2006.01)

(21) Application number: **14160771.3**

(22) Date of filing: **19.03.2014**

(54) **Hemt temperature sensor**

HEMT-Temperatursensor

Capteur de température TGME

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**23.09.2015   Bulletin 2015/39**

(73) Proprietor: **NXP B.V.**
**5656 AG Eindhoven (NL)**

(72) Inventor: **Risbud, Dilip Madhav**
**Redhill Surrey RH1 1SH (GB)**

(74) Representative: **Hardingham, Christopher Mark
NXP SEMICONDUCTORS
Intellectual Property Group
Abbey House
25 Clarendon Road
Redhill, Surrey RH1 1QZ (GB)**

(56) References cited:
**WO-A1-01/84630          US-A1- 2003 020 132
US-A1- 2010 019 279          US-A1- 2011 260 174
US-A1- 2013 256 699          US-A1- 2013 301 680
US-A1- 2014 028 357**

## Description

This invention relates to an integrated structure comprising a high-electron-mobility transistor (HEMT). It also relates to an integrated circuit package and an electronic device incorporating said structure.

Self-heating is a known problem in power semiconductors and is of particular importance in AlGaN/GaN power HEMTs due to the typical high power dissipation levels. GaN HEMTs and GaN diodes have been observed to suffer from thermal effects during device testing and in application boards under static and dynamic conditions. The effect of self-heating manifests itself in the static DC I-V measurements where a pronounced negative slope in the saturation region is observed as power dissipation is increased. Current collapse is "memory" effect present in HEMTs in which the current flow through the device is dependent on voltages previously applied to the device. The effect of current collapse is worsened at higher temperatures. Gate drive and drain-to-source biasing of GaN power semiconductors therefore requires careful attention during the design of a system. In applications such as power factor correction (PFC), boost circuits or motor drive control, the devices reach high temperatures very rapidly during switching and often exhibit thermal runaway causing the destruction of the device as it exceeds the maximum junction temperature (Tj) and the package limitations.

The documents US2013/0256699, US2010/0019279, WO01/84630 and US2003/0020132 all disclose a temperature sensing element for providing temperature protection of a HEMT element.

According to the invention an integrated structure comprising a high-electron-mobility transistor (HEMT) and a temperature sensing arrangement integrated with the HEMT is provided as recited in claim 1. This may be advantageous as the HEMT, which may comprise a GaN based device, has integrated temperature sensing. This may make the HEMT more reliable. The temperature sensing arrangement or a part thereof may be integrated in the active area, drain region, source region or gate region of the HEMT structure. Utilising semiconductor structures that can act as a temperature sensing arrangement may allow the temperature of the HEMT to be measured effectively.

The structure may further including a temperature protection element configured to receive the signal indicative of temperature and control the HEMT. Integration of a protection circuit with the HEMT may be advantageous. According to the invention the temperature sensing arrangement comprises a plurality of temperature sensing elements. The temperature sensing elements are distributed over the HEMT. This is advantageous as the temperature sensing element can be placed at different points over the die area occupied by the HEMT. The temperature of the HEMT during use may not be uniform and therefore providing a plurality of temperature sensing elements provides a more reliable measure of subsections of the HEMT that may be experiencing excessive temperatures.

The temperature sensing element(s) may comprise a Schottky Barrier Diodes (SBDs). The temperature sensing elements may utilise a two dimensional electron gas due to piezoelectric polarisation. The HEMT may be a Gallium Nitride based HEMT structure. This is advantageous as SBDs may be formed in a GaN process along with the HEMT, without any additional mask or processing steps. It will be appreciated that GaN based processes may include multiple layers of AlGaN to make a superlattice and metals such as nickel or nickel-vanadium to form a Schottky gate.

The temperature sensing elements may be arranged in a gate finger region of the HEMT. It may be advantageous to locate the temperature sensing elements here as it may allow for multiple sensing elements to be placed, potentially leading to more accurate temperature distribution information.

The temperature protection element may be configured to provide a HEMT control signal to shut down the HEMT in response to the signal indicative of temperature. Alternatively, the temperature protection element may be configured to provide temperature information to a device remote from the structure, which may be for use with external protection or compensation schemes.

The temperature protection element may be located adjacent a source node of the HEMT. This may provide convenient electrical coupling to said element, at least for test purposes.

The temperature protection element may be configured to provide the HEMT control signal to a gate of the HEMT. Thus, a gate-source voltage (Vgs) may be supplied to the HEMT to shut down its operation. In case of a depletion mode HEMT (normally-ON), Vgs may comprise a negative voltage below a threshold voltage Vth. For an enhancement mode HEMT (normally-off), Vgs may comprise a positive voltage below the threshold voltage Vth. It will be appreciated that when Vgs is drawn below the threshold voltage Vth (turn-on threshold voltage) of the HEMT, the HEMT switches from its ON state to OFF state, thus shutting it down.

The temperature sensing arrangement may comprise a proportional to absolute temperature circuit (PTAT) configured to output the signal indicative of temperature. The PTAT circuit may utilise two or more temperature sensing elements. The PTAT circuit may comprise a first and a second Shottky Barrier Diodes that are each configured to be supplied with a constant current. The constant current may be supplied by a current source, which may be formed by at least one GaN HEMT and a resistance. The first and second Shottky Barrier Diodes may be configured to operate at different current densities. The first and second SBDs may have different areas. The voltage between the first and second SBDs may comprise the signal indicative of temperature. Thus, the SBDs may act as temperature sensors in the PTAT circuit. The temperature sensing arrangement may include a proportional to absolute temperature circuit configured to use a pair of temperature sensing elements adapted to operate at different current densities to derive the signal indicative of temperature.

The temperature sensing arrangement may comprise a temperature to frequency convertor. The temperature sensing arrangement may comprise a first temperature sensing element and a second temperature sensing element configured to control an oscillator. The oscillator may comprise a multi-vibrator or square wave generator configured to generate the signal indicative of temperature from the signal received from the first and second temperature sensing elements, which may comprise two GaN SBDs. The oscillator may be configured to generate the signal indicative of temperature having a frequency that is a function of the temperature of the HEMT. The first and second SBDs may have substantially the same area. The first and second SBDs may be arranged in parallel and with opposed polarities and configured to control the oscillator. The temperature sensing arrangement may comprise a multi-vibrator configured to use a signal derived from a pair of temperature sensing elements, the multi-vibrator configured to generate the signal indicative of temperature signal having a frequency that is a function of the temperature of the HEMT.

The temperature protection element may include a comparison element configured to compare the sensed temperature with a predetermined set point and, if the set point is exceeded, generate a logic signal. The sensed temperature may comprise the temperature signal from the PTAT circuit or the oscillator/multi-vibrator/square wave generator. The set point may comprise a predetermined voltage signal that represents a threshold temperature to which the sensed temperature is compared.

The comparison element may comprise a frequency to voltage converter and may be configured to compare the frequency of the signal indicative of temperature with a predetermined set point and, if the predetermined set point is reached or exceeded, generate an indicator signal, which may comprise logic signal. The comparison element may comprise a phase locked loop configured to latch when the frequency of the signal indicative of temperature matches a predetermined threshold frequency that represents a threshold temperature. Such a latch may use an exclusive OR logic arrangement to act as a phase detector.

Thus, the comparison element may be configured, by way of the indicator/logic signal, to indicate if the sensed temperature rises above a threshold. This signal can be used to control the HEMT to prevent the temperature rising further. It will be appreciated that the comparison element may provide an indicator signal that has more than two states and may provide a gradient of control signals to the HEMT.

The temperature protection element may include a level converter configured to, in response to the indicator signal or logic signal, generate a control signal for application to a gate of the HEMT. The level convertor is advantageous as it can convert an electrical property of the indicator or logic signal, typically its voltage, such that it can act directly on a gate of the HEMT to control the power through the HEMT and therefore control its temperature.

The level convertor may comprise a polarity inverter. In certain modes of operation of the HEMT, it may be necessary for the control signal to have an inverse polarity to the logic signal. Thus, the polarity inverter may be provided to make this conversion.

The HEMT, temperature sensing arrangement and temperature protection circuit may be integrated in the same semiconductor body on the same die. This provide a compact temperature protection solution for a HEMT.

According to a second aspect of the invention we provide an integrated circuit package including the structure defined in the first aspect.

The package may include a lead to receive a negative power supply and lead to receive a positive power supply.

According to a third aspect of the invention we provide an electronic device including the structure defined in the first aspect. The electronic device may comprise a GaN based switch-mode power supply or motor control system.

There now follows, by way of example only, a detailed description of embodiments of the invention with reference to the following figures, in which:

Figure 1 shows a plan view of an example integrated structure;

Figure 2 shows a schematic diagram of an example integrated structure;

Figure 3 shows a schematic diagram of a second example integrated structure;

Figure 4 shows an example PTAT circuit;

Figure 5 shows an example comparator circuit;

Figure 6 shows an example level converter circuit; and

Figure 7 shows an example temperature to frequency converter.

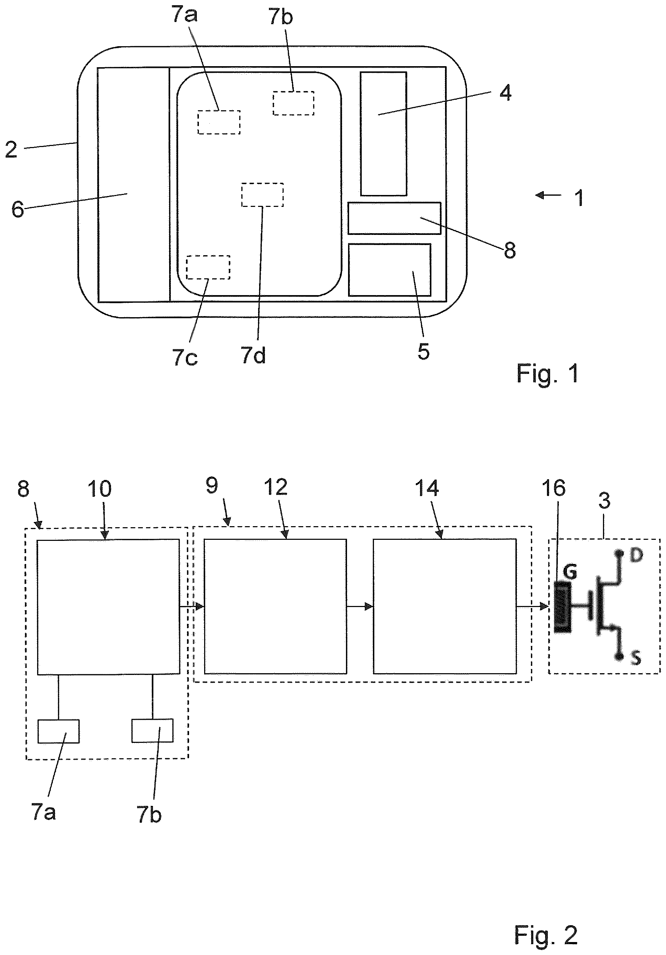

Figure 1 shows an integrated structure 1 formed in a semiconductor body 2. The structure 1 comprises a HEMT 3 having a source region 4, a gate region 5 and a drain region 6. The structure further includes a plurality of temperature sensing elements 7a-d that are integrated in the GaN semiconductor body 2 in an active area of the HEMT 3. The temperature sensing elements comprise Schottky Barrier Diodes (SBD). Accordingly, the SBDs 7 are distributed over an area that defines the extent of the HEMT 3. In Figure 1, the SBDs 7a-d are provided in the conduction channel of the HEMT 3. The temperature sensing elements are electrically isolated from the HEMT 3 and may be placed at any location over the body 2 on which the HEMT is located. The temperature sensing elements form part of a temperature sensing arrangement 8 which is configured to provide a signal indicative of the temperature of the HEMT 3. The structure 1 includes a temperature protection element 9 configured to use the signal from the temperature sensing arrangement to provide a control signal for controlling the HEMT 3. The temperature sensing arrangement 8 may be configured to provide a temperature signal for processing by external circuitry. Alternatively, and as shown in this embodiment, the temperature protection element 9 may be configured to use the information from the temperature sensing arrangement 8 to control the operation of the HEMT.

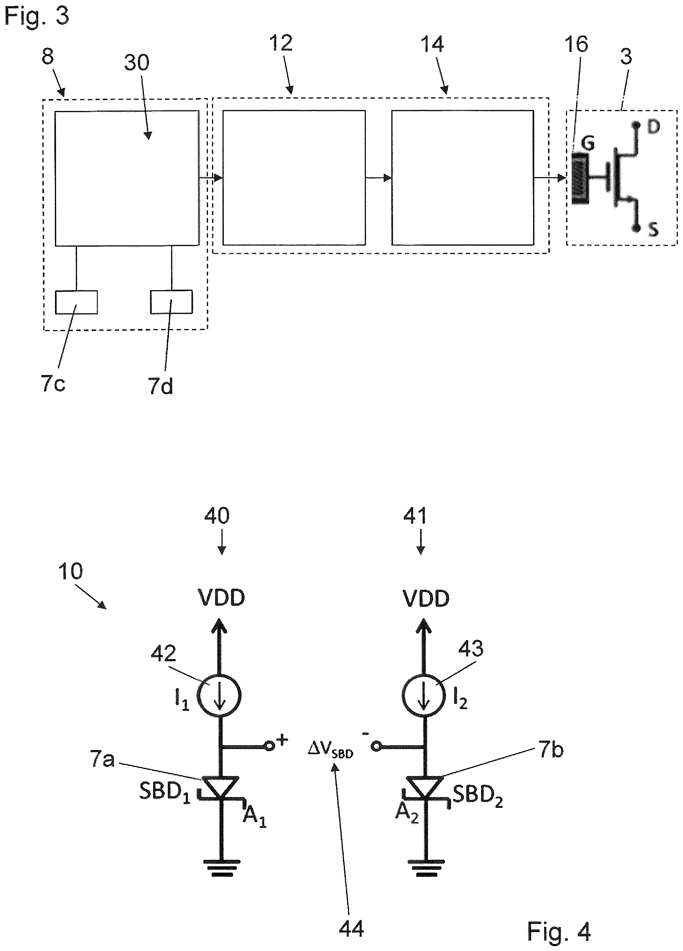

Figure 2 shows a first example of the components parts of the temperature sensing arrangement 8 and the temperature protection element 9. The temperature sensing arrangement 8 comprises a proportional to absolute temperature (PTAT) circuit 10. The PTAT circuit is shown in more detail in Figure 4. The circuit 10 is configured to use pairs of SBDs 7a-d as temperature sense elements. The PTAT circuit 10 is configured to provide an output voltage that is linearly proportional to the temperature of the HEMT. Thus, the PTAT circuit 10 provides, at its output, a temperature signal.

With reference to Figure 4, the PTAT circuit 10 is shown utilising two of the SBDs 7a and 7b in two branches 40 and 41. Each branch of the PTAT circuit 10 is supplied with a constant current. Current sources 42 and 43 are shown applying the constant current to the SBDs 7a, 7b. The current sources 42 and 43 may be embodied as any appropriate constant current circuitry as will be understood by those skilled in the art. The SBDs 7a and 7b are configured such that one of them has a greater area than the other. In this example, SBD 7a has an area ten times that of SBD 7b. It will be appreciated that other multiple or area difference may be used. The voltage difference $\Delta V_{SBD}$ between the voltage across the first SBD 7a and the second SBD 7b forms the temperature signal 44 of the PTAT circuit 10. Thus, a temperature dependent output voltage ($\Delta V_{SBD}$) is generated by operating the GaN SBDs 7a, 7b at different current densities using area scaling of the SBDs. The current sources 42 and 43 may be designed using GaN HEMTs and resistors. The SBDs in a PTAT circuit configuration thus act as temperature sense elements. $V_{PTAT} = V_t ln(\frac{A2}{A1})$ where A1 = area of SBD 7a and A2 = area of SBD 7b and A1 = 10*A2.

The temperature protection element 9 comprises a comparison element comprising a comparator 12 configured to receive the temperature signal 44, compare it to a predetermined threshold temperature (such as 200°C for example) and, in response to the threshold temperature being exceeded generate a logic signal. Thus, the comparator 12 may be configured to generate a logical "0" signal when the temperature detected by the temperature sensing arrangement is below the threshold and a logical "1" signal when the predetermined temperature has been exceeded. It may be advantageous for the logical "1" signal representing the predetermined temperature being exceeded to comprise a higher voltage than the logical "0" as the voltage can be used as a control signal for the HEMT 3. It will be appreciated that the two states of the logic signal may have any magnitude or sign and need not be limited to established logic voltage levels.

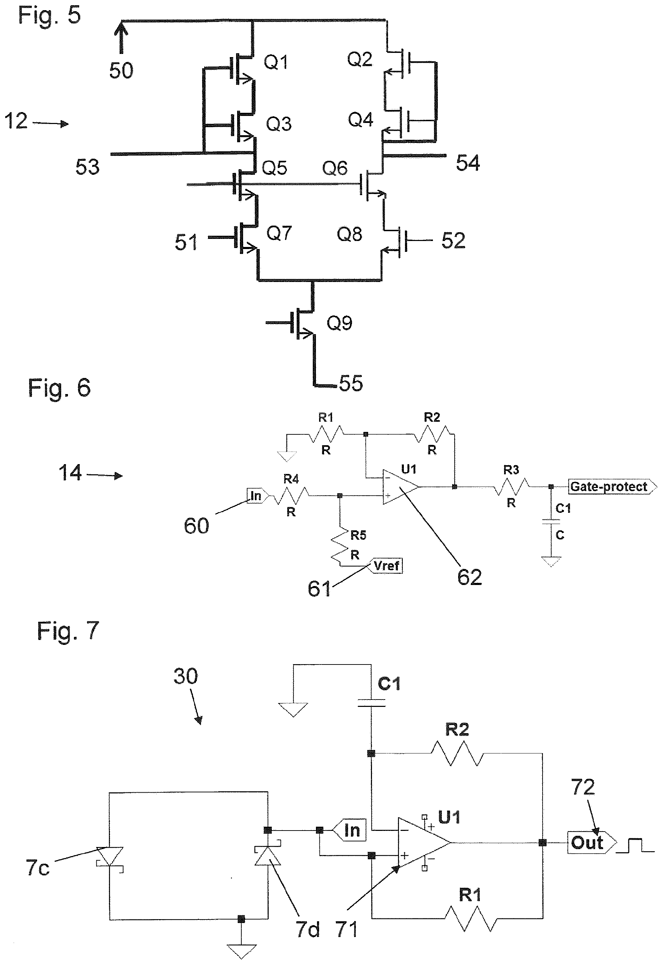

The comparator 12 is shown in more detail in figure 5. The comparator 12 is designed using depletion mode (D-mode) HEMTs and, in particular, only D-mode HEMTs, Q1-Q9. A bias signal is applied at 50 to the drain terminal of HEMTs Q1 and Q2. The HEMTs Q1 to Q4 form a pull up arrangement to lift the input signal to a particular level. A boost signal is applied to the gate terminals of HEMTs Q5 and Q6, which increases the DC gain by increasing the output resistance of the HEMTs. An external reference voltage, e.g. -1.5V is applied at the gate terminal of HEMT Q9. For the HEMTs acting as loads (Q1, Q2, Q3, Q4), the width-to-length ratio (W/L) of the D-mode HEMT load Q1, Q2 is (much) smaller than Q3, Q4. This arrangement gives a higher output resistance than a single HEMT load. The temperature signal 44 is applied at a first input 51. A signal representing the threshold is applied at a second input 52. The comparator provides two outputs 53 and 54. The first output 53 comprises the logic signal. The second output 54 gives a complementary output. A bias signal is applied at 55 to the source terminal of the HEMT Q9.

The temperature protection element 9 further comprises a level converter 14. The level convertor 14 is configured to convert the electrical properties of the logic signal received from the comparator 12 so that it is suitable for control of the HEMT 3. Thus, the logic signal may be level-shifted to an appropriate voltage to apply a gate-source voltage Vgs to the HEMT 3. The HEMT may be shut off by application of such a signal. Alternatively, the HEMT may operate in depletion mode in which case the gate-source threshold voltage, Vgs(th), required to shut down the HEMT 3 may be negative. Accordingly the control signal from the level converter 14 will need to be more negative than Vgs(th) in order to shut-down the HEMT 3. Thus, the level converter 14 may include a polarity inverter to invert the polarity of the logic signal.

The level convertor 14 may be configured to monitor the operational state of the HEMT 3 to ensure it converts the logic signal to an appropriate voltage, with the appropriate polarity, to shut-down the HEMT 3. Alternatively the level convertor 14 may be configured to output a control signal of predetermined magnitude and polarity.

The level converter is shown in more detail in Figure 6. The level converter 14 receives the logic signal at input 60 and a reference voltage at input 61. The input signal is thus amplified by an amplifier 62 to an appropriate voltage for output as the control signal (labelled "gate protect" in Figure 6). The level shifter may be a standard circuit. It may consist of resistor dividers and GaN HEMTs and SBDs as active components.

Accordingly, as shown in Figure 2, the control signal is applied to the gate 16 of the HEMT 3 to shut it down such that it adopts the off state. Accordingly, the temperature of the HEMT 3 may then decrease, as it is inoperational. The temperature sensed by the temperature sensing elements 7 will decrease until the comparator 12 determines that the temperature signal no longer exceeds the predetermined threshold temperature. The comparator then sets the logic signal to logic "0" and the voltage applied to the gate of the HEMT 3 is removed, allowing it to operate normally. The comparator 12 may be configured to wait for the temperature to fall beneath the threshold temperature by a predetermined amount before providing a logic "0" signal. This may be advantageous to prevent oscillations as the HEMT temperature quickly rises and falls around the threshold temperature as it is activated and deactivated by the temperature protection element 9.

Figure 3 shows a second example of the temperature sensing arrangement 8 and the temperature protection element 9. In this example, the proportional to absolute temperature (PTAT) circuit 10 is replaced with a voltage to frequency (VTF) converter 30. The VTF converter 30 is shown in more detail in Figure 7 and is configured to use two SBDs 7c, 7d as temperature sensing elements. The SBDs 7c, 7d have the same area. The SBDs are arranged in parallel with opposing polarities and provide an input to the non-inverting terminal of an amplifier 71. The frequency output of the circuit 30 is proportional to the forward or knee voltage of the SBDs 7c, 7d at the input. The VTF convertor 30 comprises a square wave generator (a multi-vibrator) that uses the pair of SBDs 7c, 7d to generate a signal at output 72 of an appropriate frequency. The output frequency is proportional to the temperature sensed by the SBDs 7a, 7b and thus the output frequency goes up as the temperature goes up. The square wave signal comprises a temperature signal where its frequency represents temperature.

Further, in this second example, the comparison device 12 comprises a frequency to voltage converter circuit. The voltage is compared to a predetermined threshold voltage and, if the threshold is exceeded a logic "1" signal is generated. In an alternative example, the comparison device comprises a frequency capture circuit which may comprise a phase locked loop (PLL) configured to latch on to the frequency of interest (i.e. a threshold frequency that corresponds to a predetermined threshold temperature) using an XOR logic gate as a phase detector. Thus, when the temperature signal frequency reaches a threshold value corresponding to an over-temperature condition, the PLL circuit generates a logic "1" signal. The PLL provides a voltage output which responds quickly to the temperature changes. Thus, the PLL acts as a frequency to voltage converter. It will be appreciated that the logic levels need not correspond to known logic voltage levels and the comparison device may generate any appropriate signal to indicate that the temperature has reached and/or exceeded the predetermined threshold.

The logic signal is received by the level convertor 14 as in the previous example. Accordingly a control signal is generated to control the HEMT 3. An error integrator may be provided between the temperature sensing arrangement 8 and the temperature protection element 9. The error integrator may form part of the phase locked loop arrangement.

The temperature protection element 9 may be formed solely of Schottky diodes, resistors, capacitors and depletion mode transistors. These components can be readily formed using GaN semiconductor technology. It may be necessary for the structure 1 to receive a negative voltage power as well as positive voltage power. The use of enhancement mode transistors rather than depletion mode transistors may obviate the need for a negative voltage power supply.

In the above examples, the SBDs 7 are shown distributed over the die area occupied by the HEMT 3. In other examples, the SBDs may be arranged in a string or an array or in groups. The SBDs may be arranged at a centre of the HEMT 3 in the conduction channel. A string or an array comprises a plurality of SBDs connected in series rather than a single SBD. This may be advantageous in order to generate a large enough voltage and differentiate the signal from the noise. In the examples described above the temperature sensing arrangement, comparison element and level convertor are formed of SBDs, D-mode HEMTs, resistors and capacitors. The PTAT circuit is designed using SBDs, resistors and D-mode HEMTs. The comparator uses D-mode HEMTs and SBDs for biasing as well as for load and drive transistors. The level convertor uses GaN based resistor dividers and D-mode HEMT as an active device. It will be appreciated that other configurations using other components integrated using GaN technology may be possible.

**Claims**

1. An integrated structure comprising a high-electron-mobility transistor (HEMT) and a temperature sensing arrangement integrated with the HEMT, the temperature sensing arrangement configured to provide a signal indicative of temperature for providing temperature protection for the HEMT, **characterized in that** the temperature sensing arrangement comprises a plurality of temperature sensing elements distributed over the HEMT.

2. A structure according to claim 1, in which the structure further includes a temperature protection element configured to receive the signal indicative of temperature and control the HEMT.

3. A structure according to claim 1, in which each temperature sensing element comprises a Schottky Barrier Diode.

4. A structure according to any preceding claim, in which the HEMT is a Gallium Nitride based HEMT.

5. A structure according to claim 2, in which the temperature protection element is configured to provide a HEMT control signal to shut down the HEMT in response to the signal from the temperature sensing arrangement.

6. A structure according to any preceding claim, in which the temperature sensing arrangement includes a proportional to absolute temperature circuit configured to use a pair of temperature sensing elements adapted to operate at different current densities to derive the signal indicative of temperature.

7. A structure according to any one of claim 1 to 5, in which the temperature sensing arrangement comprises a multi-vibrator configured to use a signal derived from a pair of temperature sensing elements, the multi-vibrator configured to generate the signal indicative of temperature signal having a frequency that is a function of the temperature of the HEMT.

8. A structure according to claim 2, in which the temperature protection element includes a comparison element configured to compare the signal indicative of temperature with a predetermined set point and, if the set point is exceeded, generate a logic signal.

9. A structure according to claim 8, in which the comparison element comprises a frequency to voltage converter and is configured to compare the sensed temperature with a predetermined set point and, if the predetermined set point is exceeded, generate a logic signal.

10. A structure according to claim 8 or claim 9, in which the temperature protection element includes a level converter configured to, in response to the logic signal, generate a control signal for application to a gate of the HEMT.

11. A structure according to claim 10, in which the level convertor comprises a polarity inverter.

12. A structure according to any preceding claim in which the HEMT, temperature sensing arrangement and temperature protection circuit are integrated in the same semiconductor body.

13. An integrated circuit package including the structure defined in any one of claims 1 to 12.

14. An electronic device including the structure defined in any one of claims 1 to 12.

**Patentansprüche**

1. Eine integrierte Struktur aufweisend einen Hoch-Elektronen-Beweglichkeits Transistor (HEMT) und eine temperaturfühlende Anordnung, die mit dem HEMT integriert ist, wobei die temperaturfühlende Anordnung konfiguriert ist zum Bereitstellen eines Signals, das indikativ ist für eine Temperatur zum Bereitstellen von Temperaturschutz für den HEMT, **dadurch gekennzeichnet, dass** die temperaturfühlende Anordnung eine Mehrzahl von temperaturfühlenden Elementen aufweist, die über den HEMT verteilt sind.

2. Eine Struktur gemäß Anspruch 1, in welcher die Struktur ferner ein Temperaturschutz Element umfasst, das konfiguriert ist zum Empfangen des Signals, das indikativ ist für eine Temperatur und zum Steuern des HEMT.

3. Eine Struktur gemäß Anspruch 1, in welcher jedes temperaturfühlende Element eine Schottky Barriere Diode aufweist.

4. Eine Struktur gemäß irgendeinem der vorhergehenden Ansprüche, in welcher der HEMT ein Gallium Nitrid basierter HEMT ist.

5. Eine Struktur gemäß Anspruch 2, in welcher das Temperaturschutz Element konfiguriert ist zum Bereitstellen eines HEMT Steuersignals zum Abschalten des HEMT als Antwort auf das Signal von der temperaturfühlenden Anordnung.

6. Eine Struktur gemäß irgendeinem der vorhergehenden Ansprüche, in welcher die temperaturfühlende Anordnung einen proportional zur Absoluttemperatur Schaltkreis umfasst, der konfiguriert ist zum Verwenden eines Paars von temperaturfühlenden Elementen, die eingerichtet sind, bei verschiedenen Stromdichten zu arbeiten, um das Signal, das indikativ ist für eine Temperatur, herzuleiten.

7. Eine Struktur gemäß irgendeinem der Ansprüche 1 bis 5, in welcher die temperaturfühlende Anordnung einen Multivibrator aufweist, der konfiguriert ist zum Verwenden eines Signals, das hergeleitet ist von einem Paar von temperaturfühlenden Elementen, wobei der Multivibrator konfiguriert ist zum Erzeugen des Signals, das indikativ ist für ein Temperatur Signal, wobei das Signal eine Frequenz hat, die eine Funktion von der Temperatur des HEMT ist.

8. Eine Struktur gemäß Anspruch 2, in welcher das Temperaturschutz Element ein Vergleichselement umfasst, das konfiguriert ist, das Signal, das indikativ ist für eine Temperatur, mit einem vorbestimmten Sollwert zu vergleichen und, wenn der Sollwert überschritten ist, ein logisches Signal zu generieren.

9. Eine Struktur gemäß Anspruch 8, in welcher das Vergleichselement einen Frequenz zu Spannung Konverter aufweist und konfiguriert ist zum Vergleichen der gefühlten Temperatur mit einem vorbestimmten Sollwert und zum Erzeugen eines logischen Signals, wenn der vorbestimmte Sollwert überschritten ist.

10. Eine Struktur gemäß Anspruch 8 oder Anspruch 9, in welcher das Temperaturschutz Element einen Level Konverter umfasst, der konfiguriert ist zum Erzeugen eines Steuersignals zur Anwendung auf ein Gatter von dem HEMT als Antwort auf das logische Signal.

11. Eine Struktur gemäß Anspruch 10, in welcher der Level Konverter einen Polaritätswandler aufweist.

12. Eine Struktur gemäß irgendeinem der vorhergehenden Ansprüche, in welcher der HEMT, die temperaturfühlende Anordnung und der Temperaturschutz Schaltkreis in demselben Halbleiterkörper integriert sind.

13. Ein Integrierter Schaltkreis Package aufweisend die Struktur, wie in irgendeinem der vorhergehenden Ansprüche 1 bis 12 definiert.

14. Eine elektronische Vorrichtung aufweisend die Struktur, wie in irgendeinem der vorhergehenden Ansprüche 1 bis 12 definiert.

**Revendications**

1. Structure intégrée comprenant un transistor à haute mobilité électronique (HEMT) et un agencement de détection de température intégré avec le HEMT, l'agencement de détection de température étant configuré pour délivrer un signal représentatif de la température pour assurer la protection thermique du HEMT, **caractérisé en ce que** l'agencement de détection de température comprend une pluralité d'éléments de détection de température distribués sur le HEMT.

2. Structure selon la revendication 1, la structure comportant en outre un élément de protection thermique configuré pour recevoir le signal représentatif de la température et commander le HEMT.

3. Structure selon la revendication 1, dans laquelle chaque élément de détection de température comprend une diode à barrière de Schottky.

4. Structure selon une quelconque revendication précédente, dans laquelle le HEMT est un HEMT à base de nitrure de gallium.

5. Structure selon la revendication 2, dans laquelle l'élément de protection thermique est configuré pour délivrer un signal de commande de HEMT pour arrêter le HEMT en réponse au signal provenant de l'agencement de détection de température.

6. Structure selon une quelconque revendication précédente, dans laquelle l'agencement de détection de température comporte un circuit proportionnel à la température absolue configuré pour utiliser une paire d'éléments de détection de température adaptés pour fonctionner à différentes densités de courant pour dériver le signal représentatif de la température.

7. Structure selon l'une quelconque des revendications 1 à 5, dans laquelle l'agencement de détection de température comprend un multivibrateur configuré pour utiliser un signal dérivé d'une paire d'éléments de détection de température, le multivibrateur étant configuré pour générer le signal représentatif de la température, le signal ayant une fréquence qui est une fonction de la température du HEMT.

8. Structure selon la revendication 2, dans laquelle l'élément de protection thermique comporte un élément de comparaison configuré pour comparer le signal représentatif de la température avec une consigne prédéterminée et, si la consigne est dépassée, générer un signal logique.

9. Structure selon la revendication 8, dans laquelle l'élément de comparaison comprend un convertisseur fréquence-tension et est configuré pour comparer la température détectée avec une consigne prédéterminée et, si la consigne prédéterminée est dépassée, générer un signal logique.

10. Structure selon la revendication 8 ou la revendication 9, dans laquelle l'élément de protection thermique comporte un convertisseur de niveau configuré pour, en réponse au signal logique, générer un signal de commande pour application à une grille du HEMT.

11. Structure selon la revendication 10, dans laquelle le convertisseur de niveau comprend un inverseur de polarité.

**12.** Structure selon une quelconque revendication précédente dans laquelle le HEMT, l'agencement de détection de température et le circuit de protection thermique sont intégrés dans le même corps semi-conducteur.

**13.** Boîtier de circuit intégré comportant la structure définie dans l'une quelconque des revendications 1 à 12.

**14.** Dispositif électronique comportant la structure définie dans l'une quelconque des revendications 1 à 12.

Fig. 1

Fig. 2

Fig. 3

Fig. 4

**Fig. 5**

**Fig. 6**

**Fig. 7**

**EP 2 922 093 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20130256699 A
- US 20100019279 A
- WO 0184630 A
- US 20030020132 A